Europäisches Patentamt

European Patent Office

Office européen des brevets

(11) Publication number: **0 261 324**
**A1**

# EUROPEAN PATENT APPLICATION

(21) Application number: 87109442.1

(51) Int. Cl.4: **H01L 23/30**

(22) Date of filing: 01.07.87

(30) Priority: 26.09.86 US 912444

(43) Date of publication of application:
30.03.88 Bulletin 88/13

(84) Designated Contracting States:
DE FR GB IT

(71) Applicant: TEXAS INSTRUMENTS
INCORPORATED
13500 North Central Expressway
Dallas Texas 75265(US)

(72) Inventor: Bednarz, George A.
2800 Landershire Lane
Plano Texas 75023(US)
Inventor: Hightower, Angus W.
617 Winchester Drive
Richardson Texas 75080(US)
Inventor: Roeding, Gretchen W.
1513 Ginger Drive
Carrollton Texas 75007(US)
Inventor: Test, Howard R.
1908 Webster Drive
Plano Texas 75075(US)

(74) Representative: Leiser, Gottfried, Dipl.-Ing. et
al
Patentanwälte Prinz, Leiser, Bunke & Partner
Manzingerweg 7
D-8000 München 60(DE)

(54) Plastic package for large chip size integrated circuit.

(57) An integrated circuit device having a combination of IC bar (3), bar pad (4) and, possibly, a heat spreader centered vertically in a molded plastic package (10) to minimize cracking of the plastic package due to thermally generated stresses.

Fig. 8

# PLASTIC PACKAGE FOR LARGE CHIP SIZE INTEGRATED CIRCUIT

## BACKGROUND OF THE INVENTION

### 1. Field of the Invention

This invention pertains to packaging for integrated circuits, and more particularly, to plastic packaging for large semiconductor chips.

### 2. Description of the Related Art

As modern integrated circuits (ICs) become larger and more complex, it has become increasingly more difficult to build reliable integrated circuit devices which have plastic packaging material. This is nowhere more evident than in the manufacture of Dynamic Random Access Memory (DRAM) integrated circuit devices.

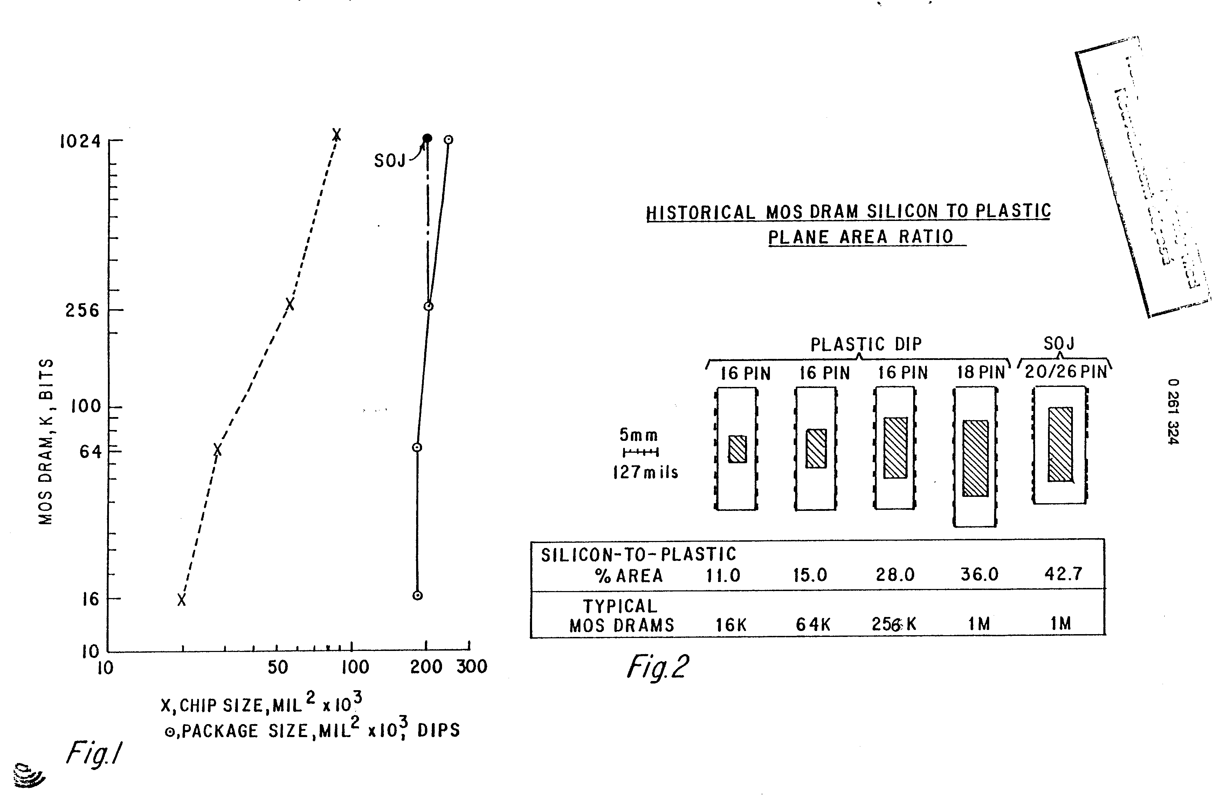

Maximum memory capacity for single DRAM devices has increased from 16K bits to the current one megabit, and soon is expected to reach four megabits. As memory size has increased, package size has not increased proportionately as much as the physical size of the semiconductor material. That is, the larger memory capacity devices have packages in which a larger percentage of volume is occupied by the semiconductor circuit, or chip. This has come about due to the necessity of keeping the footprint or space occupied by an integrated circuit device as small as possible. Figure 1 is a plot of DRAM size in kilobits versus semiconductor chip size for the dotted curve and package size for the solid curve. Chip size refers to the surface area of its upper surface, while package size refers to the area of maximum cross section which occurs at the parting line, or plane in which the leads protrude from the package. As memory went from 16K to 1024K (one megabit), chip size nearly quadrupled while package size increased by about fifty percent for Dual In-line Packages (DIPs) and even less for Small Outline J lead packages (SOJs). Figure 2 is a plan view showing the relative sizes of semiconductor chips (shaded area) with respect to their plastic packages or DRAMs ranging in size from 16K to one megabit. As can be seen, semiconductor-to-package area ratios range from 11% for 16K DIP devices to 42.7% for one megabit SOJ devices.

With the advent of integrated circuit devices large enough to give semiconductor-to-package ratios in excess of 30%, it has been found that plastic packages are susceptible to warping and cracking during the production process. The semiconductor, leadframe, and plastic packaging materials have different coefficients of thermal expansion, which causes stresses to develop in the plastic as the integrated circuit device is heated and cooled during its manufacture and subsequent testing. When the stresses become sufficiently great, the warping and cracking takes place. Specifically, thermal stresses are generated during molding and post mold curing of the plastic package and during temperature cycle testing of the fully assembled integrated circuit device. During temperature cycling, the device is taken from -65 to +150 degrees C, according to MIL Standard 883, Method 1010.6, Condition C. It is evident that as semiconductor chips have become larger with respect to the size of the surrounding plastic package, thermal expansion and contraction of the chip and package produce greater forces on the packages than was true with relatively smaller chip sizes.

Cracks in the plastic package are undesirable because they allow moisture and ionic contaminants to enter the integrated circuit device and to come into contact with the integrated circuit. Corrosion of the circuit elements within the package and subsequent failure of the device are the likely consequences. Integrated circuit devices with cracks in their packages will likely fail one of the industry standard package integrity tests in which the devices are subjected to a combination of high humidity, temperature and pressure, resulting in lowered quality and reliability. Of course, cracks in the package also weaken the mechanical strength of a device.

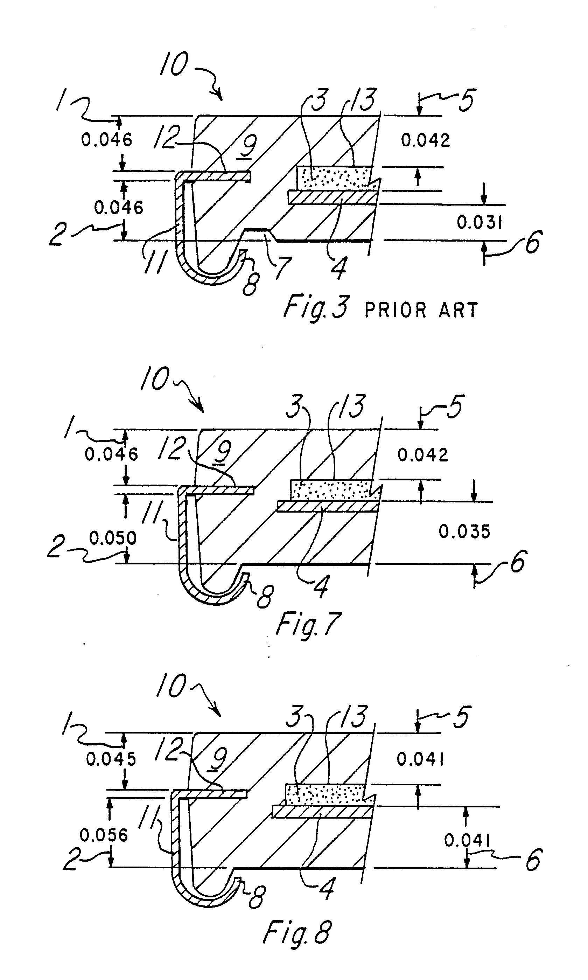

Currently, plastic DIPs and SOJs have equal thicknesses of plastic above and below that portion of the lead frame which projects externally from the package. This is illustrated in Figure 3, where a typical SOJ is shown in a cross sectional, side view, with an over lead frame thickness 1 equal to the under lead frame thickness 2. The semiconductor chip, hereinafter referred to as the IC bar 3, and bar pad 4 combination has a substantially greater over combination thickness 5 than it does an under combination thickness 6. Some other present day device configurations have under combination thicknesses substantially greater than their over combination thicknesses. Evidently, the unequal over and under thicknesses expand by different amounts, causing the plastic package to be pulled in such a manner as to cause bowing of the package, possibly resulting in cracking. Present day SOJs, and J lead devices in general, some of which have leads on all four sides of the package, also have lead pockets 7 that run the lengths of the package, next to each row of external leads 11 and are for receiving and anchoring the lead ends 8.

One disadvantage of the lead pocket 7 is that it creates a weak spot in the package by making the under combination thickness 6 less at that spot. Consequently, during temperature cycling of an SOJ, many of the cracks which do develop in the package, do so between the bar pad 4 and the lead pocket 7. However, for smaller devices with semiconductor-to-package ratios less than approximately 30%, these present day device configurations have proven satisfactory, through proper selection of construction materials, to meet required quality and reliability standards.

A further problem arises with large IC bar size integrated circuit devices, and that is the difficulty of ensuring even flow of the plastic material about the IC bar and bar pad combination which is no the dominant structure to be encased by the plastic.

SUMMARY OF THE INVENTION

The present invention overcomes many of the thermal stress cracking problems associated with present day, large, plastic packaged integrated circuit devices, by providing a device in which the over combination thickness of the plastic package is equal, or nearly equal, to the under combination thickness. When the thicknesses are equal, the expansion and contraction of the two thicknesses are the same, and do not cause the package to bow during thermal expansion and contraction. In addition, for SOJs, the lead pockets have been eliminated so that the under combination thickness no longer has thin areas. Furthermore, the manufacture of the plastic package becomes easier when the over and under thicknesses are equal since it is easier to achieve a uniform flow of plastic material about the IC bar and bar pad combination during formation of the package. The advantages of the invention are most noticeable with semiconductor-to-package ratios greater than approximately 30%. As mentioned above, this ratio is determined by comparing the upper surface area of the IV bar to the cross sectional area of the plastic package at the parting line. These areas are the important ones because they are the maximum horizontal cross sectional areas of each of the two structures.

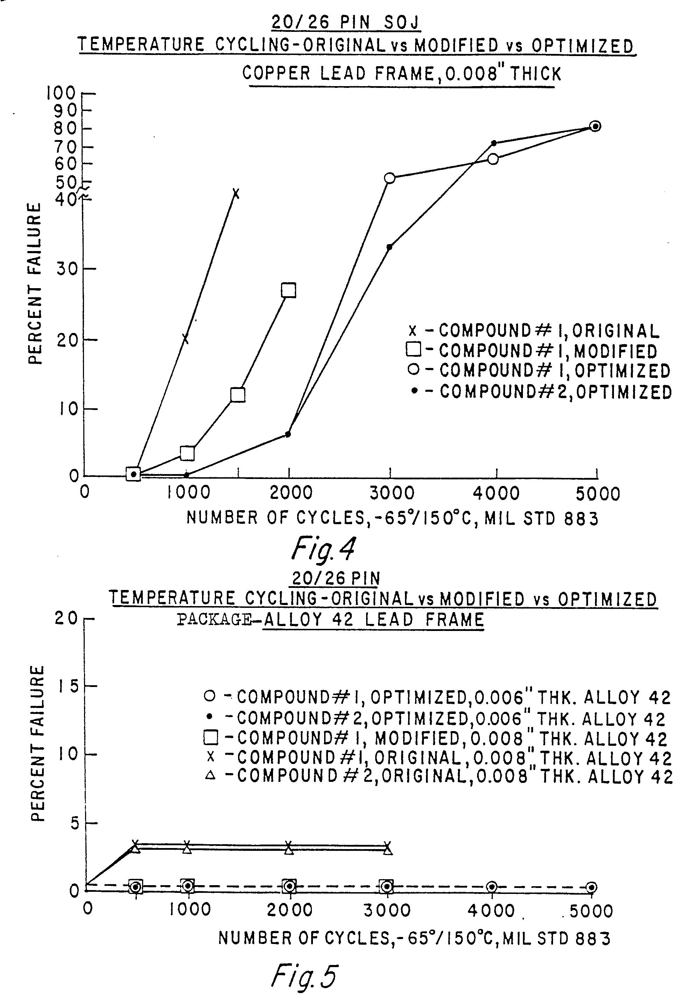

As can be seen in Figures 4, 5 and 6, the advantages of the invention begin to accrue to a device as the IC bar and bar pad combination is moved from an off center position to a position which is closer to but still not at the center of the plastic package. These Figures plainly show that the maximum benefits are received when the IC bar and bar pad combination is centered so that the over and under combination thicknesses are equal. The devices of Figures 4, 5 and 6 are silicon, plastic packed test bars identical in size and thermal properties to one megabit DRAM IC bars and plastic package with an SOJ package style.

Figure 4 is a diagram of the percentage of failures due to cracked plastic packages versus the number of temperature cycles undergone by the integrated circuit devices. Two different plastic compounds were used. The "original" devices are the present day devices with no attempt at centering the IC bar and bar pad combination; the "modified" devices are where the IC bar and bar pad combination has been moved closer to center than in present day devices; and "optimized" devices are those in which the combination is at the center of the plastic package so that the over and under thicknesses are equal. As can be seen from Figure 4, at one thousand cycles, the devices with centered IC bar and bar pad combinations essentially have no failures, while present day devices have a failure rate of approximately 20%. The lead frame material of the devices is copper, which is relatively inexpensive, but has a higher coefficient of thermal expansion than does Alloy 42 which was used for the tests summarized in Figure 5.

Like Figure 4, Figure 5 is a diagram of the percentage of failure due to cracked plastic packages versus the number of temperature cycles undergone by the devices. However, the lead frames are Alloy 42, a well known metal alloy of approximately 42% nickel and 58% iron. Alloy 42 has a coefficient of thermal expansion which is closer to that of silicon than is the coefficient of thermal expansion for copper. Thus, the failure rates for all devices are much lower for Alloy 42 since it does not expand with temperature as much as does copper, thereby producing less stress on the surrounding bar and bar pad combination in the plastic package. Nonetheless, it is seen that the optimized devices have a near zero percent failure rate due to cracking of the plastic packages, while the present day devices reach approximately three to four percent failure at five hundred cycles.

Evidently, the greatest advantages conferred by the invention occur with copper leadframe material. As noted above, copper is quite a bit less expensive and has a higher thermal conductivity than Alloy 42. In addition, copper is a more easily formed metal and is therefore easier to work with. These properties are more desirable to the industry than those of Alloy 42. In addition, Alloy 42 has approximately 42% nickel content which is a metal that increasingly is becoming more expensive and difficult to obtain.

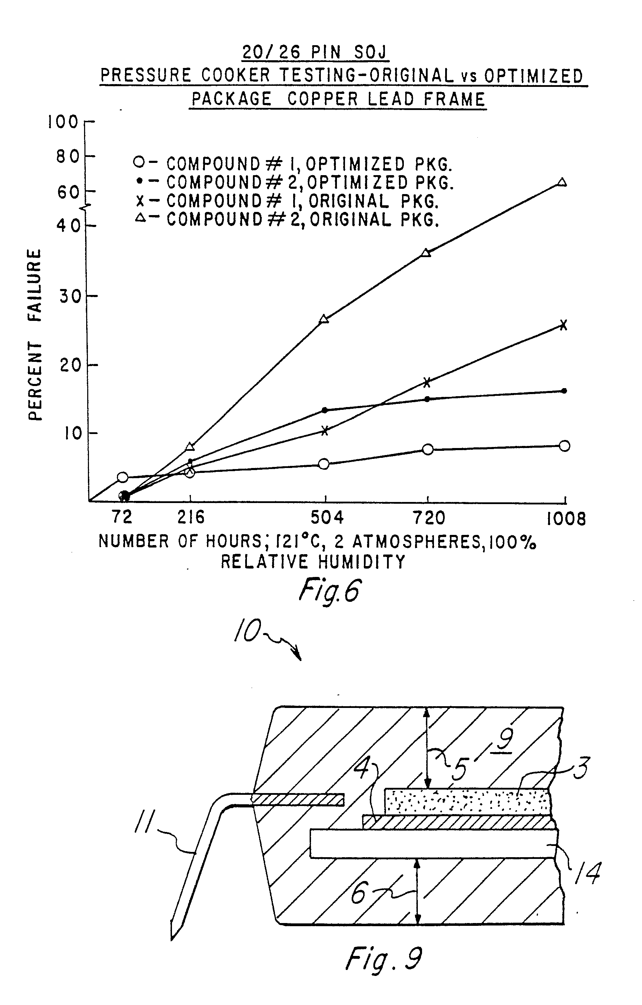

Figure 6 is a diagram of the percentage of failure due to corrosion of the bonding pads and the surface of the IC bar versus the number of hours the integrated circuit devices were subjected to an environment of two atmospheres pressure, 121 degrees C temperature, and 85% relative humidity. The bonding pads are where bonding wires make contact with the integrated circuit on the surface of the IC bar. Although there is some difference in result predicated upon the type of compound used for the plastic package, we see that after approximately seven hundred hours, there is at least 10% spread between the optimized and present day devices, for either plastic packaging compound.

In summary then, from Figures, 4 and 5 it is evident that the invention confers improved performance under conditions of varying heat, while examination of Figure 6 shows that the invention imparts improved performance under conditions of high temperature, pressure and humidity. Thus, the integrated circuit devices of the invention will give higher manufacturing yields after test time and will prove more reliable once in use, since the absence of cracks in the plastic package will significantly inhibit moisture and ionic contaminants from entering the package.

These and other objects and advantages of the invention will be apparent from a reading of the specification.

BRIEF DESCRIPTION OF THE DRAWINGS

Figure 1 is a diagram showing two curves for DRAM Metal Oxide Semiconductor (MOS) devices. The dashed line is a plot of memory capacity in kilobits versus IC bar (chip) top surface area. The solid line is· a plot of memory capacity in kilobits versus plastic package top surface area.

Figure 2 shows the relative sizes of silicon IC bars to plastic package size for integrated circuit devices ranging in size from 16K bits to one megabit.

Figure 3 is an end, cross sectional view of the left half of a prior art SOJ integrated circuit device. In particular, the vertical position in the plastic package of the combination of the IC bar and bar pad is shown. The given typical dimensions are in inches.

Figure 4 is a diagram plotting the percentage of integrated circuit device failure due to cracked packages, versus the number of temperature cycles run on the devices. The temperature test used is MIL Standard 883 specification, Method 1010.6, Condition C. The lead frame material for the tested devices is copper.

Figure 5 is a diagram like Figure 4 except that the lead frame material is Alloy 42 instead of copper.

Figure 6 is a diagram plotting the percentage of integrated circuit device failure due to IC bar bonding pad corrosion, versus the number of hours of pressure cooker testing. The conditions of the test were 121 degrees C temperature, two atmospheres pressure, and 100% relative humidity.

Figure 7 is an end, cross sectional view of the left half of an SOJ integrated device utilizing one embodiment of the invention. The given typical dimensions are in inches.

Figure 8 is an end, cross sectional view of the left half of an SOJ integrated circuit device utilizing the preferred embodiment of the invention. The given typical dimensions are in inches.

Figure 9 is an end, cross sectional view of the left half of an integrated circuit device illustrating an embodiment of the invention.

DESCRIPTION OF THE PREFERRED EMBODIMENTS

Turning to Figure 8, the preferred embodiment of the invention is shown in which the over combination thickness 5 is equal to the under combination thickness 6. That is, the combination of the IC bar 3 and the bar pad 4 is centered vertically in the plastic package 9 of the integrated circuit device 10, so that approximately as much plastic material of the package 9 is above the combination as is below it. Although a Small Outline J lead (SOJ) package style is shown, the invention is equally applicable to other package styles such as Dual In-line Pin (DIP) and Plastic Leaded Chip Carrier (PLCC), especially with plastic packaging material.

For SOJ packages, the invention as shown in figures 7 and 8, includes the omission of the lead pocket 7 shown in the prior art device of Figure 3. Present day SOJ packages include two lead pockets, one for each row of external leads 11. Lead pockets are used by present day SOJ integrated circuit devices to anchor each lead end 8. Experience has shown that the lead ends 8 really do not need to be anchored to be sufficiently strong, hence, the pockets 7 can safely be omitted, as in Figures 7 and 8, to help prevent package cracking due to thermally generated stresses.

Figure 7 shows an alternate embodiment of the invention which is a modified form of the prior art device shown in Figure 3. In this embodiment, the ratio of the under combination thickness 6 to the over combination thickness 5 is greater than is true of the same ratio in the prior art integrated circuit device 10 shown in Figure 3. As can be seen, the under combination thickness 6 was increased to be .035 inches rather than the .031 inches of the prior art device, and the over combination thickness 5 is .042 inches for both devices.

Figure 9 illustrates a further embodiment of the invention in which a heat spreader 14 is adjacent the bottom of the bar pad 4 for the purpose of conducting heat away from the IC bar 3. In this embodiment, the combination of IC bar 3, bar pad 4, and heat spreader 14 is centered vertically within the plastic package 9. That is, the over combination thickness 5 is equal to the under combination thickness 6. Typically, the heat spreader is comprised of a heat conductive material, as discussed in copending application serial number 710,259, filed March 11, 1985.

In Figures 3, 7 and 8 actual dimensions in inches have been given for such quantities as over combination thickness 5 and under combination thickness 6, however, for this invention it is not the actual measurements that are most important, but the equality or near equality of the over and under thicknesses 5 and 6. The dimensions given are of devices actually built and tested and are for purposes of facilitating explanation. They are not meant to limit the invention to such dimensions.

As can be seen in Figures 7 and 8, the invention is concerned with the central placement of the combination of IC bar 3 and bar pad 4 rather than with the vertically central placement of the external leads 11 in the plastic package. The prior art device of Figure 3 has an over lead frame thickness 1 that is equal to the under leadframe thickness 2. For both illustrated embodiments of the invention, Figures 7 and 8, the under lead frame thickness 2 is greater than the over lead frame thickness 1. The lead tips 12 are not coplanar with the bar pad 4 in order to bring the upper surface 13 of the IC bar closer to the IC bar to facilitate wire bonding from the lead tips to the IC bar, as is widely known in the industry.

## Claims

1. An integraged circuit device resistant to package cracking due to thermal stress, comprising:
an IC bar,
a bar pad, and
a plastic package surrounding the IC bar and bar pad with approximately as much plastic packaging material over the IC bar as is below the bar pad,

2. The device of Claim 1 wherein the size of the IC bar upper surface area is at least thirty percent of the size of the plastic package cross sectional area at the parting line.

3. The device of Claim 1 in which the integrated circuit device is a Dynamic Random Access Memory device which is at least one megabit in memory capacity.

4. the device of Claim 3 wherein the IC bar semiconductor material is silicon.

5. An integrated circuit device resistant to package cracking due to thermally generated stress, comprising:
a plastic package, and
an IC bar, bar pad and heat spreader combination in which the over combination thickness of the package is approximately equal to the under combination thickness of the package.

6. The integrated circuit device of Claim 5 wherein the size of the IC bar upper surface are is at least thirty percent of the size of the size of the plastic package cross sectional area at the parting line.

7. The integrated circuit device of Claim 5 in which the integrated circuit device is a Dynamic Random Access Memory device which is at least one megabit in memory capacity.

8. An IC bar and bar pad combination in which the combination is at the approximate center vertically in a molded plastic package.

9. The combination of Claim 8 in which the maximum horizontal cross sectional area of the IC bar is a substantial percentage of the maximum horizontal cross sectional area of the molded plastic package.

10. The combination of Claim 8 in which the IC bar includes a memory circuit able to store at least one megabit.

Fig.1

X, CHIP SIZE, MIL$^2$ x10$^3$
⊙, PACKAGE SIZE, MIL$^2$ x10$^3$, DIPS

MOS DRAM, K, BITS

1024  256  100  64  16  10

SOJ

10  50  100  200 300

HISTORICAL MOS DRAM SILICON TO PLASTIC PLANE AREA RATIO

| | PLASTIC DIP | | | | SOJ |
|---|---|---|---|---|---|
| | 16 PIN | 16 PIN | 16 PIN | 18 PIN | 20/26 PIN |
| SILICON-TO-PLASTIC % AREA | 11.0 | 15.0 | 28.0 | 36.0 | 42.7 |
| TYPICAL MOS DRAMS | 16K | 64K | 256 K | 1M | 1M |

5mm
127mils

Fig.2

**Fig. 3** PRIOR ART

**Fig. 7**

**Fig. 8**

## 20/26 PIN SOJ
### TEMPERATURE CYCLING-ORIGINAL vs MODIFIED vs OPTIMIZED
### COPPER LEAD FRAME, 0.008" THICK

x – COMPOUND # 1, ORIGINAL
□ – COMPOUND # 1, MODIFIED
○ – COMPOUND # 1, OPTIMIZED
• – COMPOUND # 2, OPTIMIZED

PERCENT FAILURE

NUMBER OF CYCLES, -65°/150°C, MIL STD 883

*Fig. 4*

## 20/26 PIN
### TEMPERATURE CYCLING-ORIGINAL vs MODIFIED vs OPTIMIZED
### PACKAGE–ALLOY 42 LEAD FRAME

○ – COMPOUND # 1, OPTIMIZED, 0.006" THK. ALLOY 42
• – COMPOUND # 2, OPTIMIZED, 0.006" THK. ALLOY 42
□ – COMPOUND # 1, MODIFIED, 0.008" THK. ALLOY 42
x – COMPOUND # 1, ORIGINAL, 0.008" THK. ALLOY 42
△ – COMPOUND # 2, ORIGINAL, 0.008" THK. ALLOY 42

PERCENT FAILURE

NUMBER OF CYCLES, -65°/150°C, MIL STD 883

*Fig. 5*

0 261 324

## 20/26 PIN SOJ
## PRESSURE COOKER TESTING-ORIGINAL vs OPTIMIZED
## PACKAGE COPPER LEAD FRAME

O — COMPOUND # 1, OPTIMIZED PKG.
● — COMPOUND # 2, OPTIMIZED PKG.
X — COMPOUND # 1, ORIGINAL PKG.
△ — COMPOUND # 2, ORIGINAL PKG.

PERCENT FAILURE

NUMBER OF HOURS; 121°C, 2 ATMOSPHERES, 100% RELATIVE HUMIDITY

*Fig. 6*

*Fig. 9*

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | PATENT ABSTRACTS OF JAPAN, vol. 10, no. 129 (E-403)[2186], 14th May 1986; & JP-A-60 258 941 (TOSHIBA K.K.) 20-12-1985 * Abstract * | 1,8 | H 01 L 23/30 |
| Y | Idem | 2-5 | |
| A | Idem | 6,7 | |
| X | PATENT ABSTRACTS OF JAPAN, vol. 9, no. 277 (E-355)[2000], 6th November 1985; & JP-A-60 119 756 (SHINNIHON MUSEN K.K.) 27-06-1985 * Abstract * | 1,8 | |
| | | | **TECHNICAL FIELDS SEARCHED (Int. Cl.4)** |
| Y | Idem | 2-4,9, 10 | H 01 L |
| Y | EP-A-0 118 237 (FUJITSU) * Figure 3; page 6, line 31 - page 7, line 35 * | 2,9 | |
| A | | 6 | |

--- -/-

The present search report has been drawn up for all claims

| Place of search | Date of completion of the search | Examiner |
|---|---|---|
| THE HAGUE | 30-10-1987 | CAMPLING N.C.G. |

## DOCUMENTS CONSIDERED TO BE RELEVANT

Page 2

| Category | Citation of document with indication, where appropriate, of relevant passages | Relevant to claim | CLASSIFICATION OF THE APPLICATION (Int. Cl.4) |
|---|---|---|---|
| Y | ELECTRONICS, vol. 58, no. 39, September 1985, pages 30-32, New York, US; J.R. LINEBACK: "Ready or not, here comes the megabit RAM" * Page 30 * | 3,4,10 | |
| A | Idem | 7 | |
| | --- | | |
| Y | PATENT ABSTRACTS OF JAPAN, vol. 5, no. 3 (E-40)[675], 10th January 1981; & JP-A-55 134 951 (TOKYO SHIBAURA DENKI K.K.) 21-10-1980 * Abstract * | 5 | |
| | --- | | |
| A | EP-A-0 090 608 (FUJITSU) | | TECHNICAL FIELDS SEARCHED (Int. Cl.4) |
| | ----- | | |

The present search report has been drawn up for all claims

| Place of search | Date of completion of the search | Examiner |
|---|---|---|
| THE HAGUE | 30-10-1987 | CAMPLING N.C.G. |